# EUROPEAN PATENT APPLICATION

(11) **EP 4 694 622 A2**
(43) Date of publication of application: **11.02.2026**
(21) Application number: 25193564.9
(22) Date of filing: 01.08.2025
(51) Int. Cl.: H10D 84/01, H10D 30/01, H10D 30/43, H10D 30/00, H10D 84/85

(54) **DOUBLE CELL HEIGHT ARCHITECTURE WITH FRONTSIDE AND BACKSIDE CONNECTIONS**

(30) Priority: 05.08.2024 US 202418794220
(71) Applicant: INTEL Corporation, Santa Clara, CA 95054 (US)
(72) Inventor: LI, Xia, San Diego, 92130 (US); CHEHAB, Bilal, Portland, 97202 (US); WANG, Xinning, Hillsboro, 97124 (US); APRAMEYAN, Prashanth, San Jose, 95135 (US)
(74) Representative: 2SPL Patentanwälte PartG mbB

(57) **Abstract**

Techniques are provided herein to form an integrated circuit with a double-height standard cell layout that can utilize both frontside and backside connections. The layout involves merging two of the transistors into a single wider transistor that extends along the midline of the double-height standard cell layout. Accordingly, the double-height standard cell layout may include three total transistors with one transistor being wider than the other two. The transistors may be configured as an inverter with enhanced driving capability in the double height standard cell layout. The wider transistor at the center of the double-height standard cell layout includes a source or drain region with both a topside contact and a backside contact to provide additional interconnect routing flexibility. The double-height standard cell may include an n-channel device having a first width aligned along a centerline of the double-height standard cell and two p-channel devices or vice versa.

## Description

### BACKGROUND

As integrated circuits continue to scale downward in size, a number of challenges arise. For instance, reducing the size of memory and logic cells can lead to increased parasitic effects, which may result in slower switching speeds or low device yield. Accordingly, there remain a number of non-trivial challenges with respect to forming such high-density semiconductor devices.

### BRIEF DESCRIPTION OF THE DRAWINGS

Figure 1A is a plan view of a double height standard cell layout susceptible to parasitic capacitance.
Figures 1B is a plan view of another double height standard cell layout, in accordance with an embodiment of the present disclosure.
Figures 2A and 2B are plan and cross-sectional views that illustrate one stage in an example process for forming a double height standard cell layout of an integrated circuit with frontside and backside connections, in accordance with an embodiment of the present disclosure.
Figures 3A and 3B are plan and cross-sectional views that illustrate another stage in the example process for forming a double height standard cell layout of an integrated circuit with frontside and backside connections, in accordance with an embodiment of the present disclosure.
Figures 4A and 4B are plan and cross-sectional views that illustrate another stage in the example process for forming a double height standard cell layout of an integrated circuit with frontside and backside connections, in accordance with an embodiment of the present disclosure.
Figures 5A and 5B are plan and cross-sectional views that illustrate another stage in the example process for forming a double height standard cell layout of an integrated circuit with frontside and backside connections, in accordance with an embodiment of the present disclosure.
Figures 6A and 6B are plan and cross-sectional views that illustrate another stage in the example process for forming a double height standard cell layout of an integrated circuit with frontside and backside connections, in accordance with an embodiment of the present disclosure.
Figures 7A and 7B are plan and cross-sectional views that illustrate another stage in the example process for forming a double height standard cell layout of an integrated circuit with frontside and backside connections, in accordance with an embodiment of the present disclosure.
Figures 8A and 8B are plan and cross-sectional views that illustrate another stage in the example process for forming a double height standard cell layout of an integrated circuit with frontside and backside connections, in accordance with an embodiment of the present disclosure.
Figures 9A and 9B are plan and cross-sectional views that illustrate another stage in the example process for forming a double height standard cell layout of an integrated circuit with frontside and backside connections, in accordance with an embodiment of the present disclosure.
Figures 10A and 10B are plan and cross-sectional views that illustrate another stage in the example process for forming a double height standard cell layout of an integrated circuit with frontside and backside connections, in accordance with an embodiment of the present disclosure.
Figures 11A and 11B are plan and cross-sectional views that illustrate another stage in the example process for forming a double height standard cell layout of an integrated circuit with frontside and backside connections, in accordance with an embodiment of the present disclosure.
Figures 12A and 12B are plan and cross-sectional views that illustrate another stage in the example process for forming a double height standard cell layout of an integrated circuit with frontside and backside connections, in accordance with an embodiment of the present disclosure.
Figure 13 illustrates a cross-sectional view of a chip package containing one or more semiconductor dies, in accordance with some embodiments of the present disclosure.
Figure 14 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form an integrated circuit with a double-height standard cell layout that can utilize both frontside and backside connections. The layout involves merging two of the transistors into a single wider transistor that extends along the midline of the double-height standard cell layout. According to some such examples, the double-height standard cell layout may include three total transistors with one transistor being wider than the other two. The transistors may be configured, for instance, as an inverter with enhanced driving capability in the double height standard cell layout. According to some embodiments, the wider transistor at the center of the double-height standard cell layout includes a source or drain region with both a topside contact and a backside contact to provide additional interconnect routing flexibility. The techniques can be used in any number of transistor technologies, but are particularly useful in a vertically stacked gate-all-around (GAA) (e.g., nanoribbon) transistor configuration or forksheet transistor configuration. The double-height standard cell may include, for instance, an n-channel device having a first width aligned along a centerline of the double-height standard cell, and two p-channel devices. In some such examples, each of the devices may be GAA transistors each having any number of nanoribbons extending in the same direction. Numerous variations and embodiments will be apparent in light of this disclosure.

### General Overview

As previously noted above, there remain a number of non-trivial challenges with respect to integrated circuit fabrication. A double-height standard cell layout includes two standard cells abutting one another - hence the name that it has double the height of a single standard cell. The boundaries of a standard unit cell define the layout for a single combinatorial field-effect-transistor (CFET) architecture (e.g., one n-channel transistor and one p-channel transistor). The CFET architecture in the standard unit cell can be used to provide logic circuits, such as an inverter circuit, and may be repeated across a larger layout of the integrated circuit. In the case of a double-height standard unit cell, the layout of two standard unit cells together can be repeated across the integrated circuit. The double-height standard unit cell thus includes four total transistors, which can be arranged as an enhanced drive inverter circuit (e.g., the inputs of two inverter circuits are coupled together and the outputs of the two inverter circuits are coupled together). However, the arrangement of such transistors in the double-height standard cell can cause parasitic capacitance that leads to slower switching speeds and all-around lower efficiency.

Thus, and in accordance with an embodiment of the present disclosure, techniques are provided herein to form a layout for a double height standard unit cell that combines two of the four transistors into a single wider transistor. The layout eliminates certain edges of conductive features like contacts and gate structures to reduce parasitic capacitance. According to some embodiments, a first semiconductor device includes a first semiconductor region extending lengthwise in a first direction and aligned along a midline of the double-height standard unit cell. The double-height standard unit cell layout also includes a second semiconductor device having a second semiconductor region extending lengthwise in the first direction (e.g., parallel to the first semiconductor region). A gate structure extends in a second direction substantially orthogonal to the first direction across both the first and second semiconductor regions. The first semiconductor device has a first width along the second direction and the second semiconductor device has a second width along the second direction, where the first width is greater than the second width. The first width may be, for instance, 1.5 times, 2 times, or 2.5 times greater than the second width. Other examples may be configured differently. The first semiconductor region extends from a first source or drain region to a second source or drain region. According to some embodiments, the first source or drain region includes both a topside contact and a backside contact to facilitate signal or power routing to either the frontside (topside or top surface) or backside (bottomside or bottom surface) of the first source or drain region. A topside contact over the second source or drain region may extend in the second direction across both halves of the double-height standard unit cell to contact the source or drain regions of one or more other transistors in the double-height standard unit cell.

According to an embodiment, an integrated circuit includes a first semiconductor region extending from a first source or drain region in a first direction, a second semiconductor region extending from a second source or drain region in the first direction, a gate structure extending over the first semiconductor region and the second semiconductor region in a second direction orthogonal to the first direction. Also, a backside conductive contact is on a bottom surface of the first source or drain region, and a topside conductive contact is on a top surface of the first source or drain region. The first semiconductor region has a first width along the second direction, and the second semiconductor region has a second width along the second direction that is less than the first width.

According to another embodiment, an integrated circuit includes first, second, and third semiconductor devices. The first semiconductor device comprises a first semiconductor region extending from a first source or drain region to a second source or drain region in a first direction and a gate structure extending over the first semiconductor region in a second direction substantially orthogonal to the first direction. The second semiconductor device has a second semiconductor region extending from a third source or drain region to a fourth source or drain region in the first direction, and the gate structure extends over the second semiconductor region in the second direction The third semiconductor device has a third semiconductor region extending from a fifth source or drain region to a sixth source or drain region in the first direction, and the gate structure extends over the third semiconductor region in the second direction. Also, a backside conductive contact is on a bottom surface of the first source or drain region, a first topside conductive contact is on a top surface of the first source or drain region, and a second topside conductive contact that extends along the second direction is on top surfaces of each of the second source or drain region, the fourth source or drain region, and the sixth source or drain region. The first semiconductor region has a first width along the second direction, the second semiconductor region has a second width along the second direction that is less than the first width, and the third semiconductor region has a third width along the second direction that is less than the first width.

According to another embodiment, an electronic device includes a chip package having one or more dies. At least one of the one or more dies includes a first semiconductor device having a first semiconductor region extending from a first source or drain region in a first direction and a gate structure extending over the first semiconductor region in a second direction substantially orthogonal to the first direction, and a second semiconductor device having a second semiconductor region extending from a second source or drain region in the first direction and the gate structure extending over the second semiconductor region in the second direction. Also, a backside conductive contact is on a bottom surface of the first source or drain region, and a topside conductive contact is on a top surface of the first source or drain region. The first semiconductor region has a first width along the second direction, and the second semiconductor region has a second width along the second direction that is less than the first width.

The techniques can be used with any type of non-planar transistors, including finFETs (sometimes called double-gate transistors, or tri-gate transistors), or nanowire and nanoribbon transistors (sometimes called gate-all-around transistors), to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process), or any other gate formation process. Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of a repeating double-height standard unit cell that includes one transistor with a greater width compared to the other transistors of the cell. In an example, the wider transistor may be aligned along a center line of the double-height standard unit cell and be flanked by two other transistors within the double-height standard unit cell.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

### Architecture

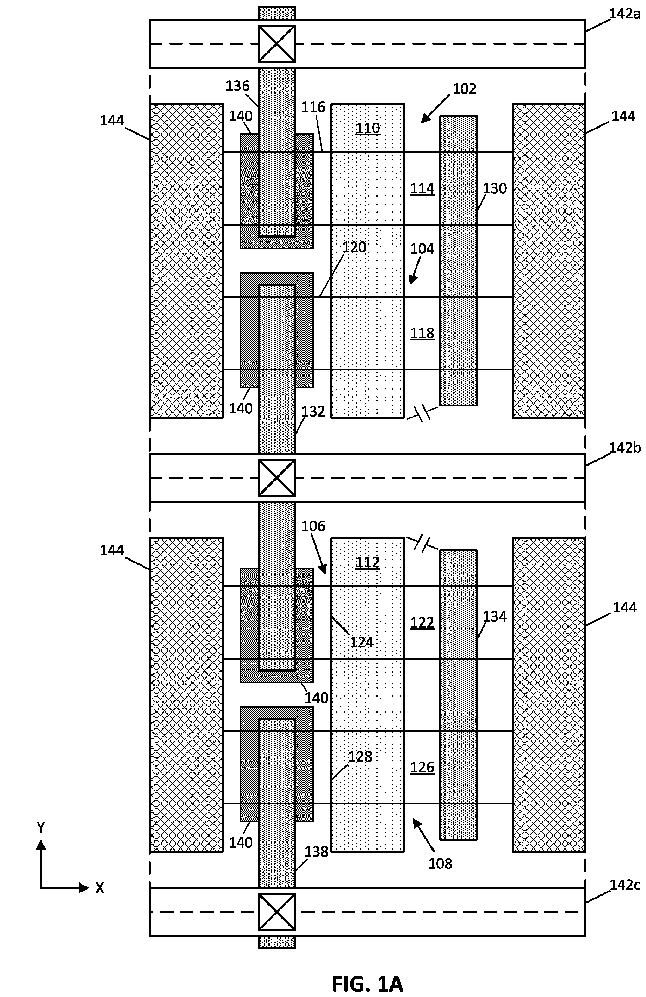

Figure 1A is a plan layout view of a double-height standard unit cell that is susceptible to parasitic capacitance. As shown, the double-height standard unit cell includes a first semiconductor device 102, a second semiconductor device 104, a third semiconductor device 106, and a fourth semiconductor device 108. The top boundary, midline boundary, and bottom boundary of the double-height standard unit cell are shown with dashed lines extending along the X-axis (e.g., a first direction). First semiconductor device 102 and second semiconductor device 104 share a first gate structure 110 that extends along the Y-axis (e.g., in a second direction) over the semiconductor regions of both first semiconductor device 102 and second semiconductor device 104. Third semiconductor device 106 and fourth semiconductor device 108 share a second gate structure 112 that extends along the Y-axis (e.g., in a second direction) over the semiconductor regions of both third semiconductor device 106 and fourth semiconductor device 108. The semiconductor region of first semiconductor device 102 extends between a first source or drain region 114 and a second source or drain region 116, the semiconductor region of second semiconductor device 104 extends between a third source or drain region 118 and a fourth source or drain region 120, the semiconductor region of third semiconductor device 106 extends between a fifth source or drain region 122 and a sixth source or drain region 124, and the semiconductor region of fourth semiconductor device 108 extends between a seventh source or drain region 126 and an eighth source or drain region 128.

A first topside contact 130 extends along the second direction across the top surfaces of both first source or drain region 114 and third source or drain region 118. A second topside contact 132 extends along the second direction across the top surfaces of both fourth source or drain region 120 and sixth source or drain region 124 while crossing the midline of the double-height standard unit cell. A third topside contact 134 extends along the second direction across the top surfaces of both fifth source or drain region 122 and seventh source or drain region 126. A fourth topside contact 136 is on the top surface of second source or drain region 116, and a fifth topside contact 138 is on the top surface of eighth source or drain region 128. Backside contacts 140 are provided beneath each of second source or drain region 116, fourth source or drain region 120, sixth source or drain region 124, and eighth source or drain region 128. Conductive layers 142a, 142b, and 142c extend parallel to one another along the first direction and are aligned to the top, midline, and bottom boundaries of the double-height standard unit cell. Conductive vias (illustrated as boxes with an 'X') extend in the Z-direction (e.g., a third direction) between conductive layers 142a - 142c and the corresponding second topside contact 132, fourth topside contact 136, or fifth topside contact 138. Note that other conductive layers and their associated vias to connect them to first gate structure 110, second gate structure 112, first topside contact 130, and third topside contact 134 are not shown for clarity.

Fin isolation structures 144 are provided on either side of semiconductor devices 102 - 108. Fin isolation structures 144 may include one or more dielectric materials that extend in the second direction within their respective gate trenches to cut through any number of fins present within those gate trenches. The fin isolation structures may be used to isolate the semiconductor devices of the double-height standard unit cell from any other devices formed along the first direction on either side of the double-height standard unit cell. Fin isolation structures 144 may include any suitable dielectric material, such as silicon nitride or any other high-k dielectric material. Fin isolation structures 144 may not be needed in situations where adjacent devices along the first direction are intended to share a given source or drain region (or where dummy transistors are employed).

The semiconductor devices of the double-height standard unit cell of Figure 1A are arranged to form an enhanced drive inverter. Thus, first semiconductor device 102 and fourth semiconductor device 108 may be both PMOS devices with second semiconductor device 104 and third semiconductor device 106 being both NMOS devices or vice versa. The input signal for the inverter is received at both first gate structure 110 and at second gate structure 112, and the output signal for the inverter is taken from both first topside contact 130 and third topside contact 134.

Some of the conductive features of the transistors of the double-height standard unit cell of Figure 1A are arranged close to one another, the result of which creates parasitic capacitance. This capacitance may be strongest near the edges of such structures, such as between the ends of first gate structure 110 and first topside contact 130, and between the ends of second gate structure 112 and third topside contact 134. These parasitic capacitances are illustrated in Figure 1A.

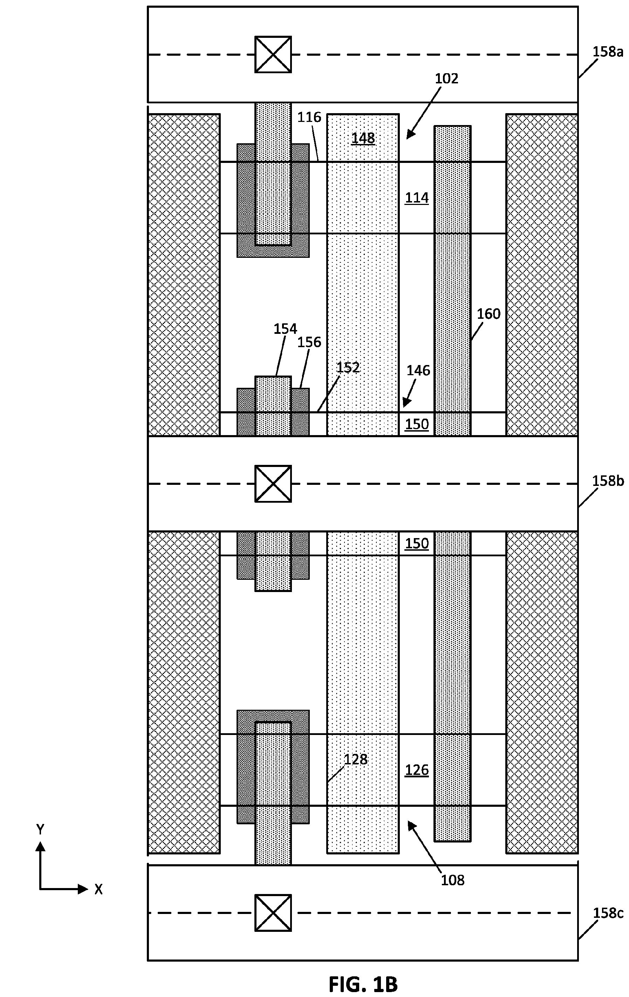

Thus, a layout for the double-height standard unit cell is provided to eliminate or reduce the parasitic capacitance of the layout described above. Figure 1B illustrates another layout for a double-height standard unit cell, according to some embodiments. In this layout, first semiconductor device 102 and fourth semiconductor device 108 may be substantially the same as described above in Figure 1A. However, second semiconductor device 104 and third semiconductor device 106 are merged together into a single wider semiconductor device 146, according to some embodiments. Semiconductor device 146 may have a width along the second direction that is at least 1.25 times, 1.5 times, 1.75 times, or 2 times wider than the width along the second direction of either first semiconductor device 102 or fourth semiconductor device 108. According to some embodiments, semiconductor device 146 includes a semiconductor region that extends along the first direction aligned with the centerline of the double-height standard unit cell. A gate structure 148 extends along the second direction across the semiconductor regions of each of first semiconductor device 102, semiconductor device 146, and fourth semiconductor device 108. The semiconductor region of semiconductor device 146 extends along the first direction from a source or drain region 150 to another source or drain region 152. The semiconductor regions of each of first semiconductor device 102, fourth semiconductor device 108, and semiconductor device 146 may be nanoribbons or nanowires extending along the first direction between corresponding source or drain regions, or fins of semiconductor material extending between corresponding source or drain regions. In either case, gate structure 148 extends over and around the semiconductor regions to form the transistor gates.

According to some embodiments, source or drain region 152 of semiconductor device 146 includes both a topside contact 154 on a top surface of source or drain region 152 and a backside contact 156 on a bottom surface of source or drain region 152. Thus, compatible frontside or backside power/ground connections can be made to the same source or drain region 152. Parallel conductive layers 158a - 158c may be provided along the top, midline, and bottom boundaries of the double-height standard unit cell. According to some embodiments, such conductive layers 158a - 158c are power or ground rails and may be made relatively wide to reduce the resistance along the layers. In some examples, conductive layers 158a - 158c may have a width along the second direction between about 10 nm and about 30 nm. Topside contact 154 may be coupled to an overhead conductive layer 158b using a via. According to some embodiments, another topside conductive contact 160 extends along the second direction and on the top surfaces of each of first source or drain region 114 and seventh source or drain region 126. Since the layout design of Figure 1B uses a single gate structure 148 and a single topside contact 160 to extend across all three transistors of the double-height standard unit cell, the parasitic edge capacitance from these elements can be eliminated or at least reduced.

According to some embodiments, the semiconductor devices of the double-height standard unit cell of Figure 1B are arranged to form an enhanced drive inverter. Thus, first semiconductor device 102 and fourth semiconductor device 108 may be both NMOS devices with semiconductor device 146 being a PMOS device or vice versa. The input signal for the inverter is received at gate structure 148 and the output signal for the inverter is taken from topside contact 160, according to some embodiments.

### Fabrication Methodology

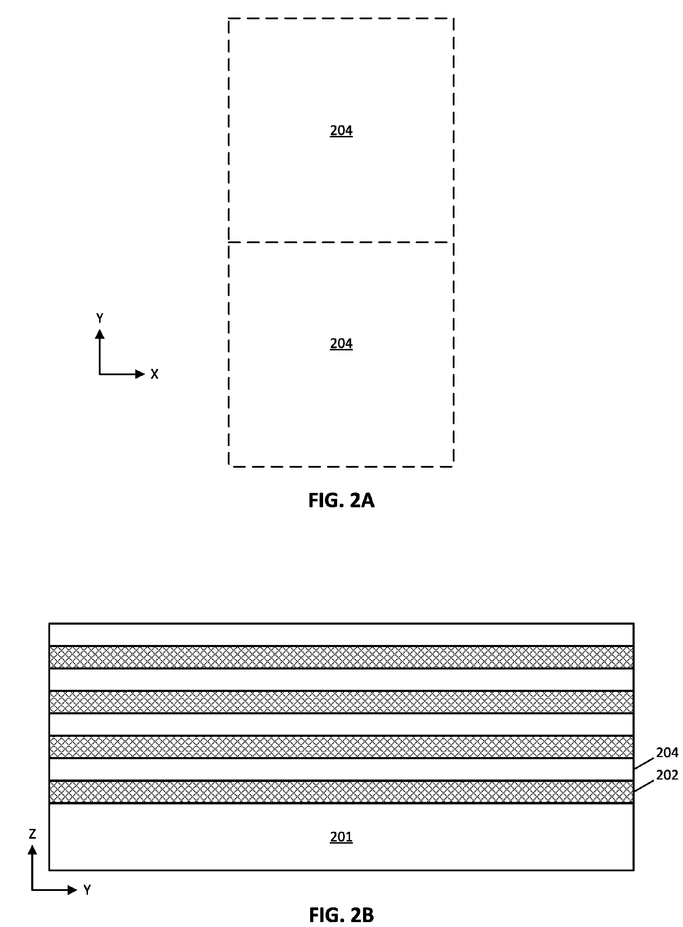

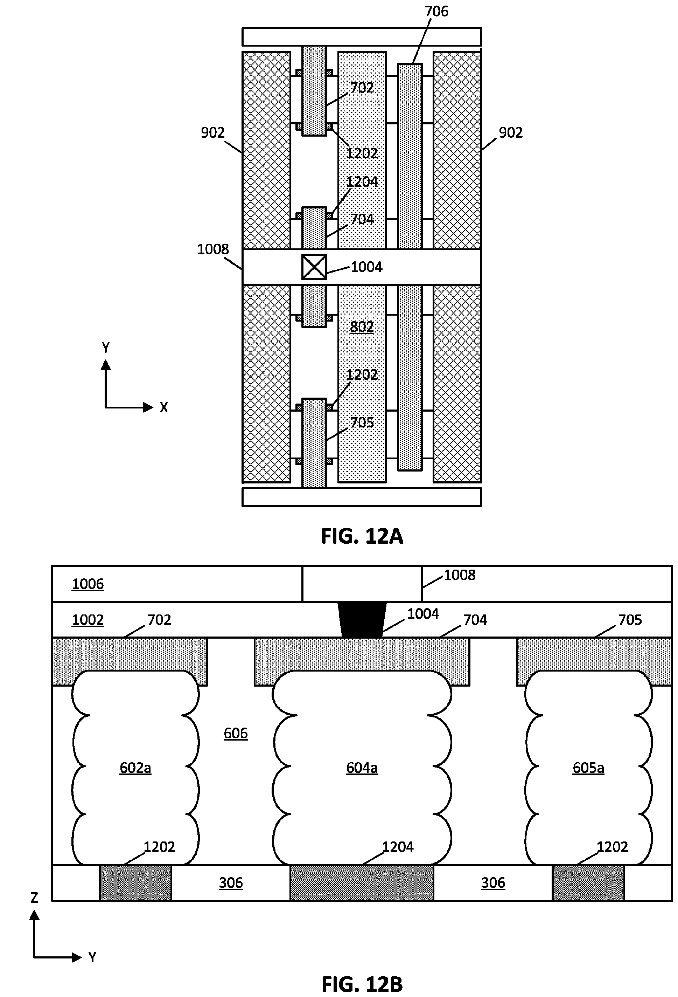

Figures 2A - 12A and 2B - 12B include plan and cross-sectional views, respectively, that collectively illustrate an example process for forming a double height standard cell layout of an integrated circuit with frontside and backside connections, in accordance with an embodiment of the present disclosure. Figures 2A - 12A represent a similar plan view as that of Figure 1B across the footprint of a double-height standard unit cell, while Figures 2B - 12B represent the corresponding cross-section view along the Y-axis at each stage of the fabrication. Each set of figures sharing the same letter shows an example structure that results from the process flow up to that point in time, so the depicted structure evolves as the process flow continues, culminating in the structure shown in Figures 12A and 12B, which is similar to the structure shown in Figure 1B. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but other materials and process parameters may be used as well, as will be appreciated in light of this disclosure. Dashed lines are used in the plan view of Figures 2A - 12A to indicate the boundaries of the double-height standard cell layout, including the centerline.

Figures 2A and 2B illustrate plan and cross-section views taken through a substrate 201 having a series of material layers formed over the substrate, according to an embodiment of the present disclosure. Alternating material layers may be deposited over a substrate 201 including sacrificial layers 202 alternating with semiconductor layers 204. The alternating layers are used to form GAA transistor structures. Any number of alternating sacrificial layers 202 and semiconductor layers 204 may be deposited over substrate 201.

Substrate 201 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 201 can be a semiconductor-on-insulator substrate having a desired semiconductor layer over a buried insulator layer (e.g., silicon over silicon dioxide). Alternatively, substrate 201 can be a multilayer substrate or superlattice suitable for forming nanowires or nanoribbons (e.g., alternating layers of silicon and SiGe, or alternating layers indium gallium arsenide and indium phosphide). Any number of substrates can be used.

According to some embodiments, semiconductor layers 204 have a different material composition than sacrificial layers 202. In some embodiments, semiconductor layers 204 are silicon germanium (SiGe) while sacrificial layers 202 include a semiconductor material suitable for use as a nanoribbon such as silicon (Si), SiGe, germanium, or III-V materials like indium phosphide (InP) or gallium arsenide (GaAs). In examples where SiGe is used in each of semiconductor layers 204 and in sacrificial layers 202, the germanium concentration is different between semiconductor layers 204 and sacrificial layers 202. For example, semiconductor layers 204 may include a higher germanium content compared to sacrificial layers 202. In some examples, sacrificial layers 202 may be doped with either n-type dopants (to produce a p-channel transistor) or p-type dopants (to produce an n-channel transistor).

While dimensions can vary from one example embodiment to the next, the thickness of each semiconductor layer 204 may be between about 5 nm and about 20 nm. In some embodiments, the thickness of each semiconductor layer 204 is substantially the same (e.g., within 1-2 nm). The thickness of each of sacrificial layers 202 may be about the same as the thickness of each semiconductor layer 204 (e.g., about 5-20 nm). Each of semiconductor layers 204 and sacrificial layers 202 may be deposited using any known material deposition technique, such as chemical vapor deposition (CVD), plasma-enhanced chemical vapor deposition (PECVD), physical vapor deposition (PVD), or atomic layer deposition (ALD), or epitaxial growth.

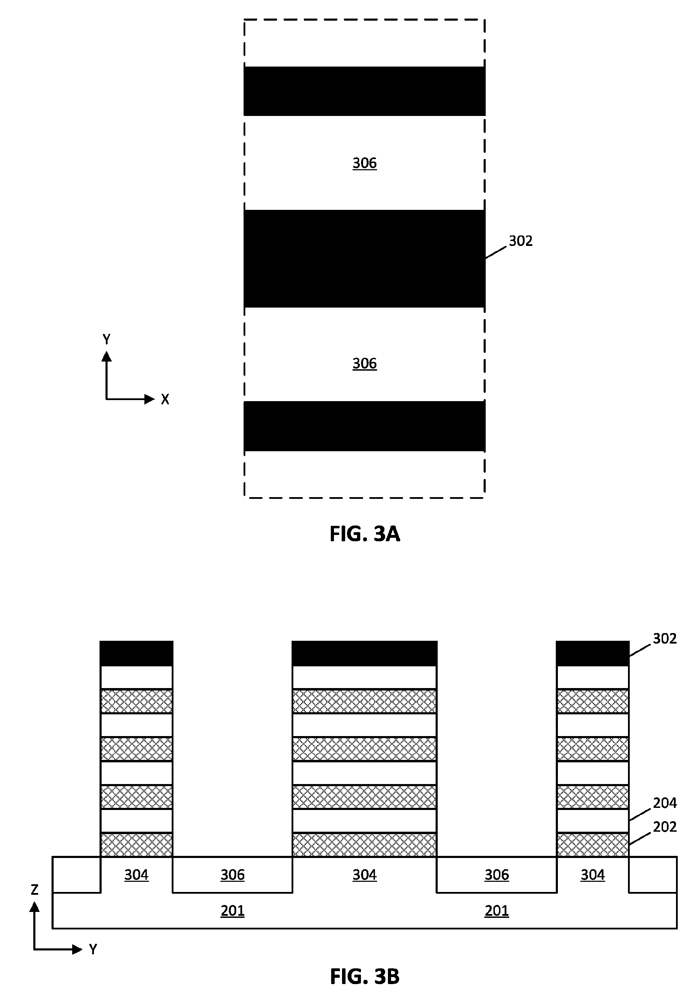

Figures 3A and 3B depict plan and cross-section views of the structure shown in Figures 2A and 2B, respectively, following the formation of a cap layer 302 and the subsequent formation of fins beneath cap layer 302, according to an embodiment. Cap layer 302 may be any suitable hard mask material such as a carbon hard mask (CHM) or silicon nitride. Cap layer 302 is patterned into rows extending along a first direction (e.g., along the X-axis as shown in Figure 3A) to form corresponding rows of fins from the alternating layer stack of sacrificial layers 202 and semiconductor layers 204. According to some embodiments, the fin along the midline boundary of the double-height standard unit cell is wider along the second direction compared to the fins on either side. For example, the middle fin of the double-height standard unit cell may be at least 25%, at least 50%, at least 75%, or at least 100% wider compared to the other fins on either side.

According to some embodiments, an anisotropic etching process through the layer stack continues into at least a portion of substrate 201. Portions of substrate 201 beneath the fins are not etched and yield subfin regions 304. The etched portion of substrate 201 may be filled with a dielectric fill 306 that acts as shallow trench isolation (STI) between adjacent fins, as seen in Figure 3B. Dielectric fill 306 may be any dielectric material such as silicon dioxide. Subfin regions 304 represent remaining portions of substrate 201 between dielectric fill 306, according to some embodiments.

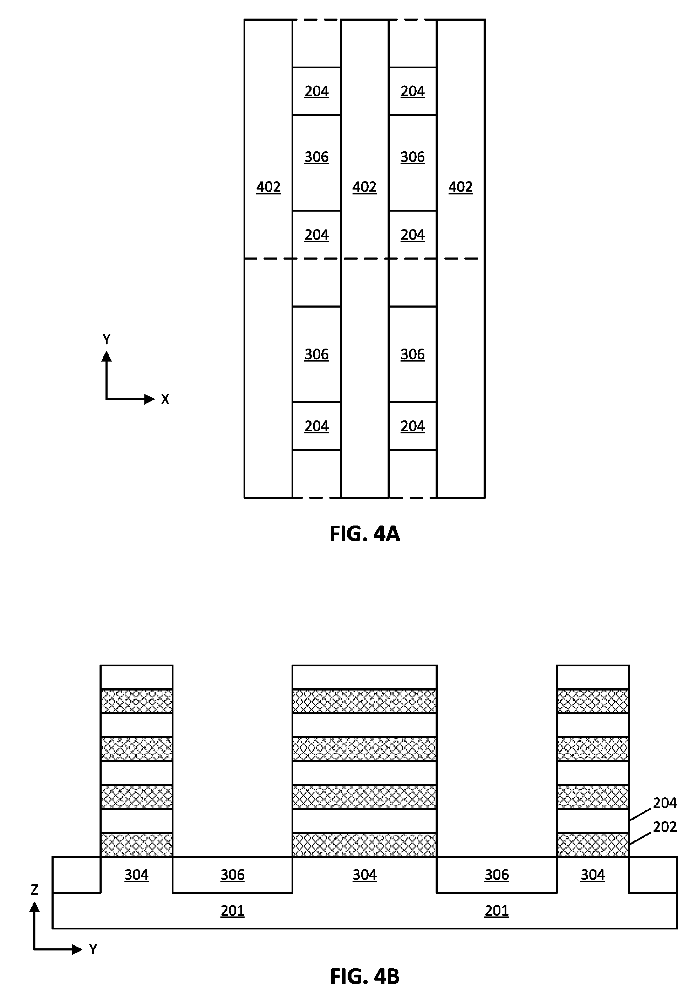

Figures 4A and 4B depict plan and cross-section views of the structure shown in Figures 3A and 3B following the formation of sacrificial gates 402, according to some embodiments. A gate masking layer may first be patterned in strips that extend orthogonally across each of the fins in a second direction (e.g., along the Y-axis as shown in Figure 4A) in order to form corresponding sacrificial gates 402 in strips beneath the gate masking layers. Afterwards, the gate masking layers may be removed or may remain as a cap layer above each sacrificial gate 402. According to some embodiments, the sacrificial gate material is removed in all areas not protected by the gate masking layers. Sacrificial gates 402 may be any material that can be selectively removed without damaging the semiconductor material of the fins. In some examples, sacrificial gates 402 includes polysilicon.

According to some embodiments, spacer structures (also referred to as gate spacers or upper gate spacers) are formed along the sidewalls of sacrificial gates 402. These spacer structures are not illustrated for clarity. The spacer structures may be deposited and then etched back such that the spacer structures remain mostly only on sidewalls of any exposed structures. According to some embodiments, the spacer structures may be any suitable dielectric material, such as silicon nitride, silicon carbon nitride, or silicon oxycarbonitride.

It should be noted that the cross-section view in Figure 4B is taken along a source/drain trench adjacent to sacrificial gates 402, and thus does not illustrate any portion of sacrificial gates 402.

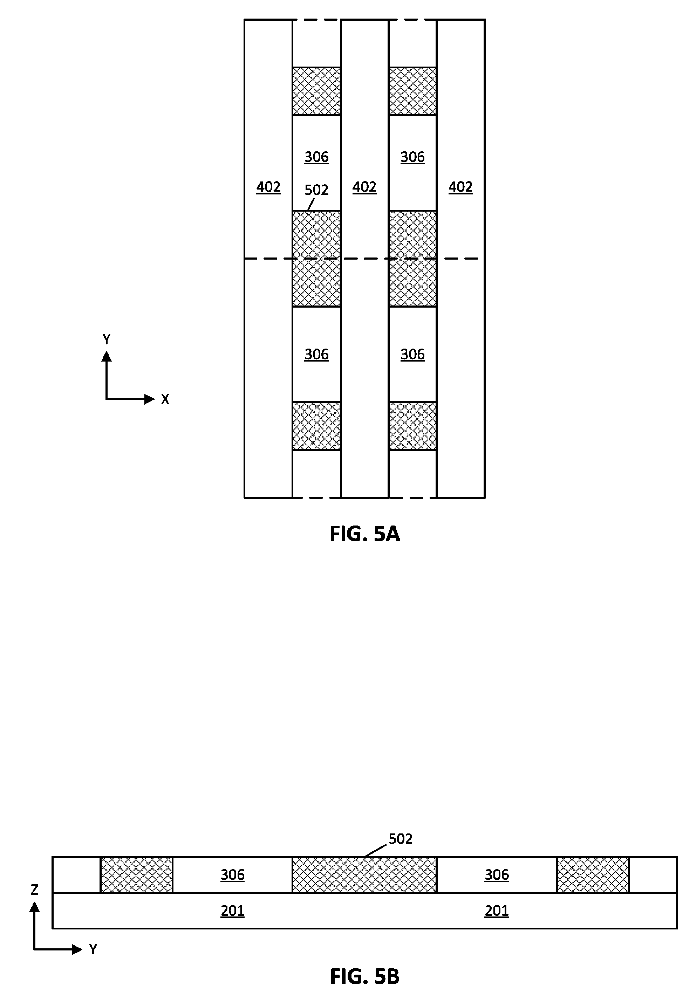

Figures 5A and 5B depict plan and cross-section views of the structure shown in Figures 4A and 4B following the removal of exposed portions of the fins not protected by sacrificial gates 402 (and the spacer structures), according to some embodiments. The exposed fin portions may be removed using any anisotropic etching process, such as reactive ion etching (RIE). The removal of the exposed fin portions creates source or drain trenches that alternate with gate trenches (currently filled with sacrificial gates 402) along the first direction, according to some embodiments. In some embodiments, at least a portion of subfin regions 304 are also removed to from recesses adjacent to dielectric fill 306. The recesses may be filled with a sacrificial material to form sacrificial plugs 502 that can be removed at a later time from the backside to expose the underside of source or drain regions. In some examples, sacrificial plugs 502 include aluminum oxide or titanium nitride.

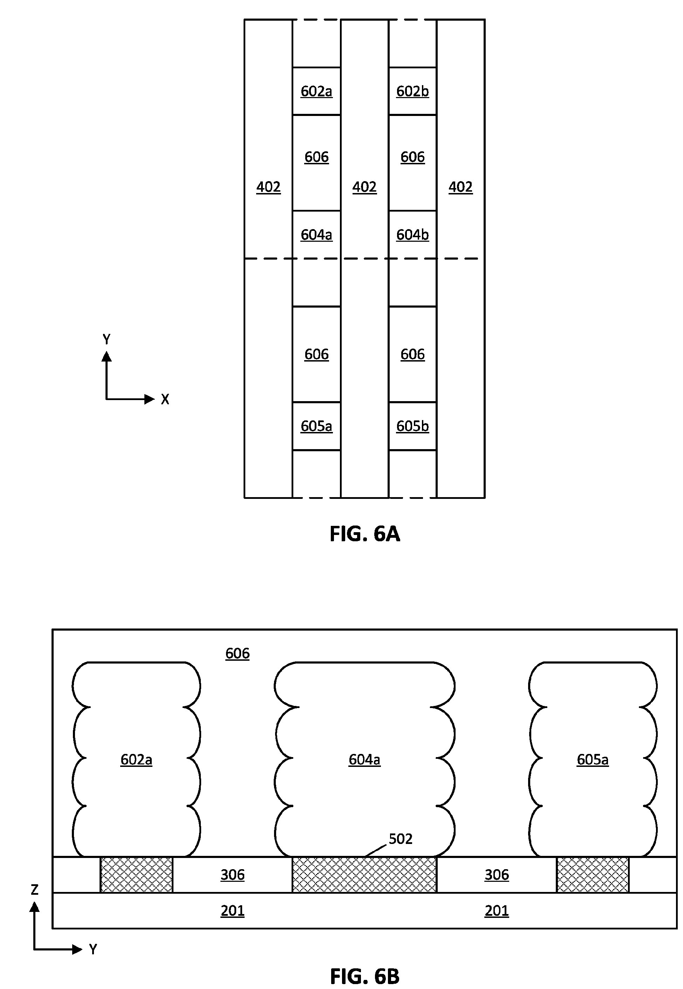

Figures 6A and 6B depict plan and cross-section views of the structure shown in Figures 5A and 5B following the formation of various source or drain regions within the source/drain trenches, according to some embodiments. Each of source or drain regions 602a/602b/604a/604b/605a/605b may be formed in the areas that had been previously occupied by the exposed fins within the source/drain trenches. According to some embodiments, the source or drain regions are epitaxially grown from the exposed semiconductor material at the ends of the semiconductor layers beneath the sacrificial gates 402. In some example embodiments, source or drain regions 602a, 602b, 605a, and 605b are p-type source or drain regions (e.g., epitaxial silicon germanium) while source or drain regions 604a and 604b are n-type source or drain regions (e.g., epitaxial silicon), or vice versa. Accordingly, source or drain regions of one dopant type may be formed first before the formation of source or drain regions of the other dopant type. Note that source or drain regions 604a and 604b may be wider along the second direction compared to the other source or drain regions 602a, 602b, 605a, and 605b of the double-height standard unit cell.

According to some embodiments, a dielectric fill 606 is provided between adjacent source or drain regions along the source/drain trench. In some examples, dielectric fill 606 occupies a remaining volume within the source/drain trench around and over each of source or drain regions 602a, 604a, and 605a, as seen in Figure 6B. Dielectric fill 606 may be any dielectric material, such as silicon dioxide. In some examples, dielectric fill 606 extends up to and planar with a top surface of sacrificial gate 402 (e.g., following a polishing procedure). A planarization process such as chemical mechanical polish (CMP) can be used to remove any excess dielectric fill 606 and planarize the structure, as shown.

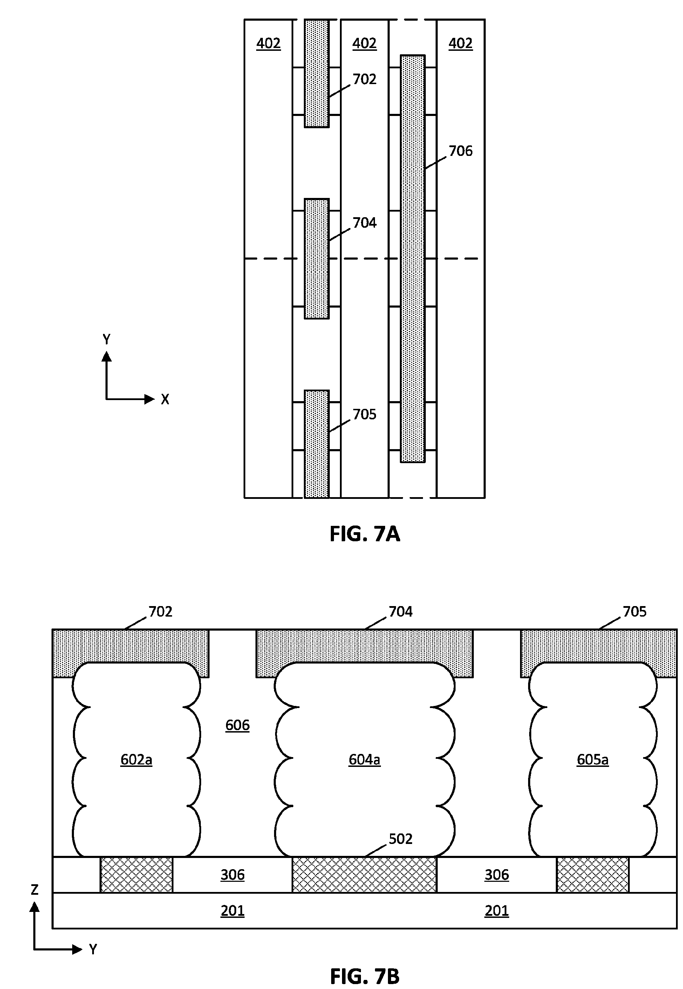

Figures 7A and 7B depict plan and cross-section views of the structure shown in Figures 6A and 6B following the formation of various topside contacts on the top surfaces of the source or drain regions, according to some embodiments. Topside contacts 702, 704, 705, and 706 may include any conductive material, such as tungsten, molybdenum, cobalt, titanium, tantalum, or ruthenium, or any alloys thereof, for making electrical contact with the underlying source or drain regions. As seen in the cross section of Figure 7B, portions of dielectric fill 606 are recessed to expose at least the top surfaces of source or drain regions 602a, 604a, and 605a, and topside contacts 702, 704, and 705 are formed within the respective recesses using any suitable metal deposition process. According to some embodiments, topside contact 706 may extend along the second direction across the top surfaces of multiple source or drain regions, such as the top surfaces of each of source or drain regions 602b, 604b, and 605b.

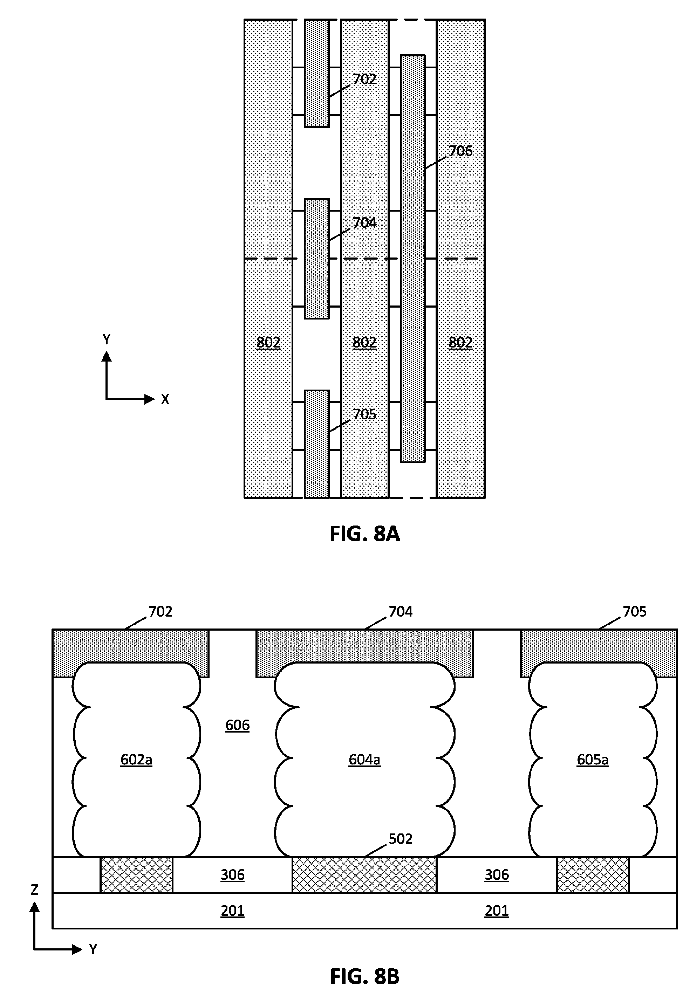

Figures 8A and 8B depict plan and cross-section views of the structure shown in Figures 7A and 7B, respectively, following the removal of sacrificial gates 402 and sacrificial layers 202 and subsequent formation of gate structures 802, according to some embodiments. In examples where gate masking layers are still present, they would be removed at this time. Once sacrificial gates 402 are removed, the fins extending between the corresponding source or drain regions are exposed.

In the example where the fins include alternating semiconductor layers, sacrificial layers 202 are selectively removed to leave behind nanoribbons that extend between corresponding source or drain regions. Each vertical set of nanoribbons represents the semiconductor region (or channel region) of a different semiconductor device. Note that the use of the term nanoribbon is not intended to exclude any particular geometries usable for a gate-all-around channel region (such as nanowires). In other embodiments, the nanoribbons of a given channel region may be a single fin structure, so as to provide a double-gate or tri-gate configuration. In still other embodiments, the nanoribbons of a given channel region may be nanosheets extending laterally from a dielectric wall, so as to provide a forksheet configuration. Sacrificial gates 402 and sacrificial layers 202 may be removed using the same isotropic etching process or different isotropic etching processes.

According to some embodiments, gate structures 802 are formed within the gate trenches over the nanoribbons or fins extending between corresponding source or drain regions. Gate structures 802 each include a gate dielectric and a gate electrode. The gate dielectric may be first formed around the nanoribbons or fin prior to the formation of the gate electrode, which may include one or more conductive layers. The gate dielectric may include any gate dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, the gate dielectric includes a layer of hafnium oxide with a thickness between about 1 nm and about 5 nm. In some embodiments, the gate dielectric may include one or more silicates (e.g., titanium silicate, tungsten silicate, niobium silicate, and silicates of other transition metals). In some cases, the gate dielectric includes a first layer on the nanoribbons or fin, and a second layer on the first layer. The first layer can be, for instance, an oxide of the semiconductor material of the nanoribbons or fin (e.g., silicon dioxide) and the second layer can be a high-k dielectric material (e.g., hafnium oxide).

The one or more conductive layers that make up the gate electrode may be deposited using electroplating, electroless plating, CVD, PECVD, ALD, or PVD, to name a few examples. In some embodiments, the gate electrode includes doped polysilicon, a metal, or a metal alloy. Example metals or metal alloys include aluminum, tungsten, cobalt, molybdenum, ruthenium, titanium, tantalum, copper, and carbides and nitrides thereof. The gate electrode may include, for instance, a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates. It should be understood that topside contacts 702, 704, 705, and 706 may be formed either before or after the formation of gate structures 802.

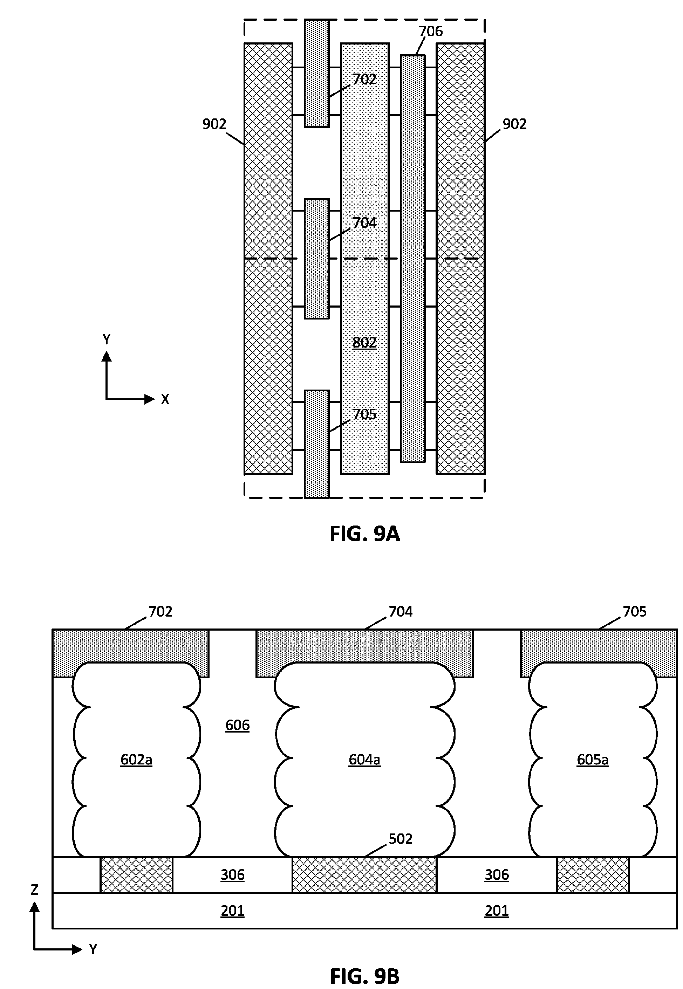

Figures 9A and 9B depict plan and cross-section views of the structure shown in Figures 8A and 8B, respectively, following the removal of the gate structures along the edges of the double-height standard unit cell, and formation of fin isolation structures 902 in place of the removed gate structures, according to some embodiments. According to some embodiments, an RIE process is used to remove the gate structures on either side of the illustrated gate structure 802 and fill those gate trenches with a dielectric material to form fin isolation structures 902. Fin isolation structures 902 may include one or more dielectric materials that extend in the second direction within their respective gate trenches to cut through any number of fins present within those gate trenches. In the illustrated example, fin isolation structures 902 isolate the semiconductor devices of the double-height standard unit cell from any other devices formed along the first direction on either side of the double-height standard unit cell. Fin isolation structures 902 may include any suitable dielectric material, such as silicon nitride or any other high-k dielectric material. Fin isolation structures 902 may not be needed in situations where adjacent devices along the first direction are intended to share a given source or drain region (or where dummy transistors are employed).

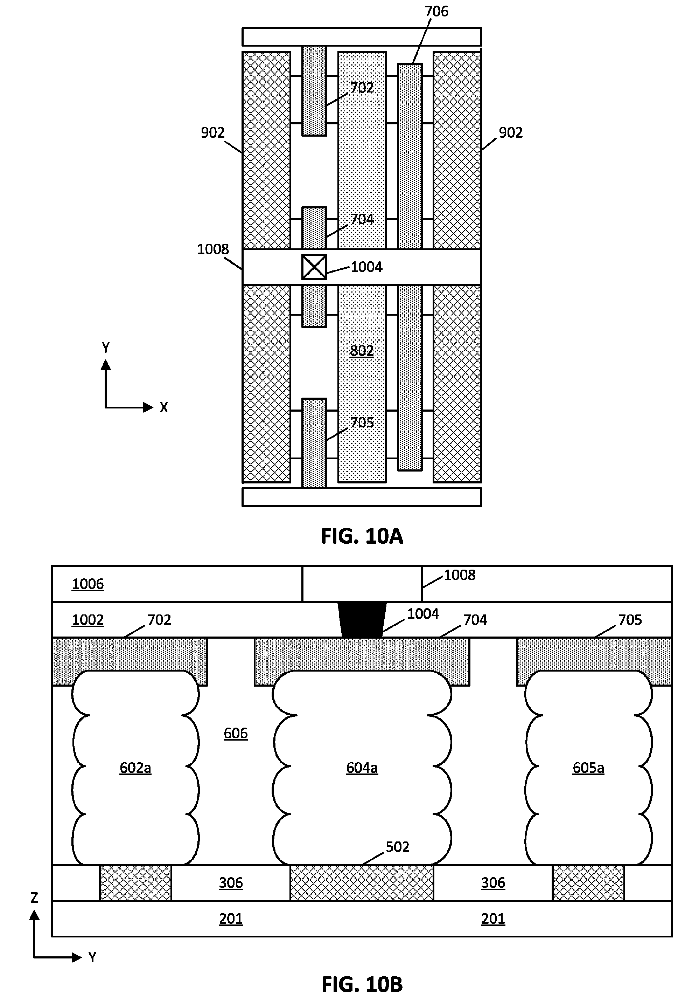

Figures 10A and 10B depict plan and cross-section views of the structure shown in Figures 9A and 9B, respectively, following the formation of a topside interconnect region having any number of interconnect layers, according to some embodiments. Each interconnect layer includes a dielectric layer along with one or more conductive vias or conductive layers. In the illustrated example, a first interconnect layer includes a first topside dielectric layer 1002 and a conductive via 1004 extending through first topside dielectric layer 1002 and contacting the underlying topside contact 704. Oher similar vias may be provided through first topside dielectric layer 1002 to contact the other topside contacts 702, 705, and 706. In the illustrated example, a second interconnect layer includes a second dielectric layer 1006 and a topside conductive layer 1008. According to some embodiments, via 1004 extends in the third direction between topside conductive layer 1008 and topside contact 704. According to some embodiments, topside conductive layer 1008 extends in the first direction along the midline boundary of the double-height standard unit cell as seen more clearly in Figure 10A. Any number of other topside interconnect layers may be formed to route power and/or signal to various transistor elements. Note that other topside conductive layers to route signals to gate structure 802 and topside contact 706 are not shown in Figure 10A for clarity.

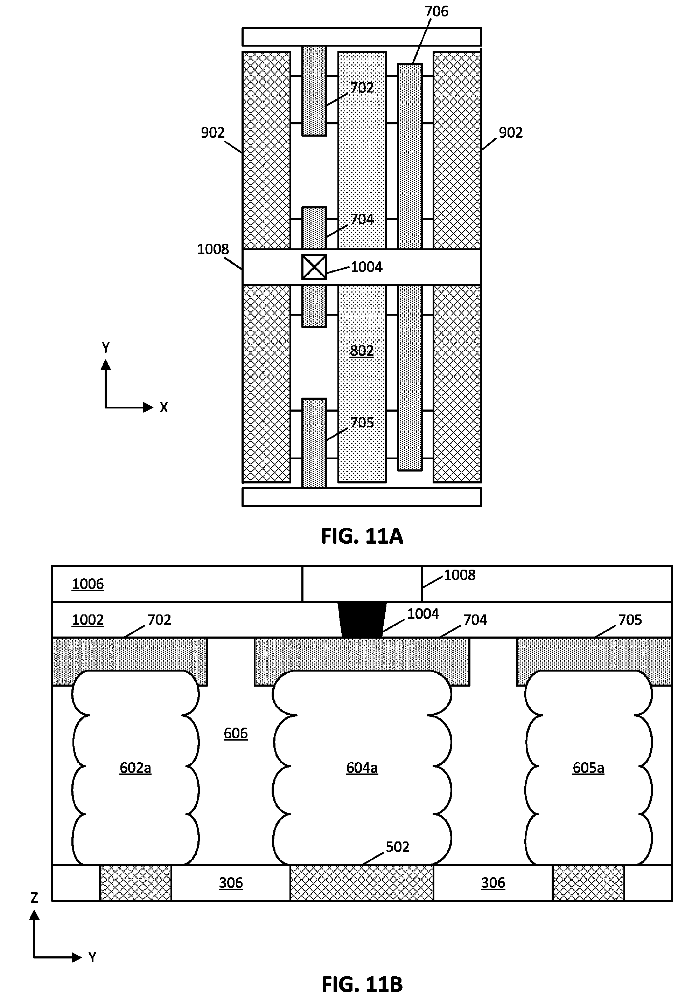

Figures 11A and 11B depict plan and cross-section views of the structure shown in Figures 9A and 9B, respectively, following the removal of substrate 201 from the backside, which exposes the bottom surface of dielectric fill 306 and sacrificial plugs 502, according to some embodiments. Substrate 201 may be removed using any combination of polishing, grinding, or isotropic etching processes.

Figures 12A and 12B depict plan and cross-section views of the structure shown in Figures 11A and 11B, respectively, following the removal of sacrificial plugs 502 and formation of backside contacts 1202 and 1204, according to some embodiments. Sacrificial plugs 502 may be removed using any suitable isotropic etching process to leave behind backside cavities that expose the bottom surfaces of various source or drain regions 602a, 604a, and 605a. One or more suitable conductive materials may then be deposited within the backside cavities to form backside contacts 1202 and 1204. In some examples, backside contacts include any of ruthenium, tungsten, cobalt, or molybdenum. In some examples, backside contacts 1202 and 1204 along with dielectric fill 306 may be part of a first backside interconnect layer, and any number of additional backside interconnect layers may be formed beneath the first backside interconnect layer to route power and/or signal to various transistor elements. According to some embodiments, source or drain region 604a is wider along the second direction compared to the flanking source or drain regions 602a and 605a, and also includes both a topside contact 704 and a backside contact 1204 to facilitate topside and/or backside connection.

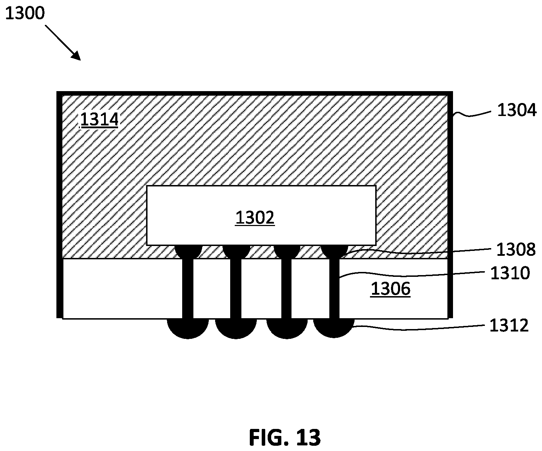

Figure 13 illustrates an example embodiment of a chip package 1300, in accordance with an embodiment of the present disclosure. As can be seen, chip package 1300 includes one or more dies 1302. One or more dies 1302 may include at least one integrated circuit having semiconductor devices, such as any of the semiconductor devices disclosed herein. One or more dies 1302 may include any other circuitry used to interface with other devices formed on the dies, or other devices connected to chip package 1300, in some example configurations.

As can be further seen, chip package 1300 includes a housing 1304 that is bonded to a package substrate 1306. The housing 1304 may be any standard or proprietary housing, and may provide, for example, electromagnetic shielding and environmental protection for the components of chip package 1300. The one or more dies 1302 may be conductively coupled to a package substrate 1306 using connections 1308, which may be implemented with any number of standard or proprietary connection mechanisms, such as solder bumps, ball grid array (BGA), pins, or wire bonds, to name a few examples. Package substrate 1306 may be any standard or proprietary package substrate, but in some cases includes a dielectric material having conductive pathways (e.g., including conductive vias and lines) extending through the dielectric material between the faces of package substrate 1306, or between different locations on each face. In some embodiments, package substrate 1306 may have a thickness less than 1 millimeter (e.g., between 0.1 millimeters and 0.5 millimeters), although any number of package geometries can be used. Additional conductive contacts 1312 may be disposed at an opposite face of package substrate 1306 for conductively contacting, for instance, a printed circuit board (PCB). One or more vias 1310 extend through a thickness of package substrate 1306 to provide conductive pathways between one or more of connections 1308 to one or more of contacts 1312. Vias 1310 are illustrated as single straight columns through package substrate 1306 for ease of illustration, although other configurations can be used (e.g., damascene, dual damascene, through-silicon via, or an interconnect structure that meanders through the thickness of substrate 1306 to contact one or more intermediate locations therein). In still other embodiments, vias 1310 are fabricated by multiple smaller stacked vias, or are staggered at different locations across package substrate 1306. In the illustrated embodiment, contacts 1312 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1312, to inhibit shorting.

In some embodiments, a mold material 1314 may be disposed around the one or more dies 1302 included within housing 1304 (e.g., between dies 1302 and package substrate 1306 as an underfill material, as well as between dies 1302 and housing 1304 as an overfill material). Although the dimensions and qualities of the mold material 1314 can vary from one embodiment to the next, in some embodiments, a thickness of mold material 1314 is less than 1 millimeter. Example materials that may be used for mold material 1314 include epoxy mold materials, as suitable. In some cases, the mold material 1314 is thermally conductive, in addition to being electrically insulating.

### Example System

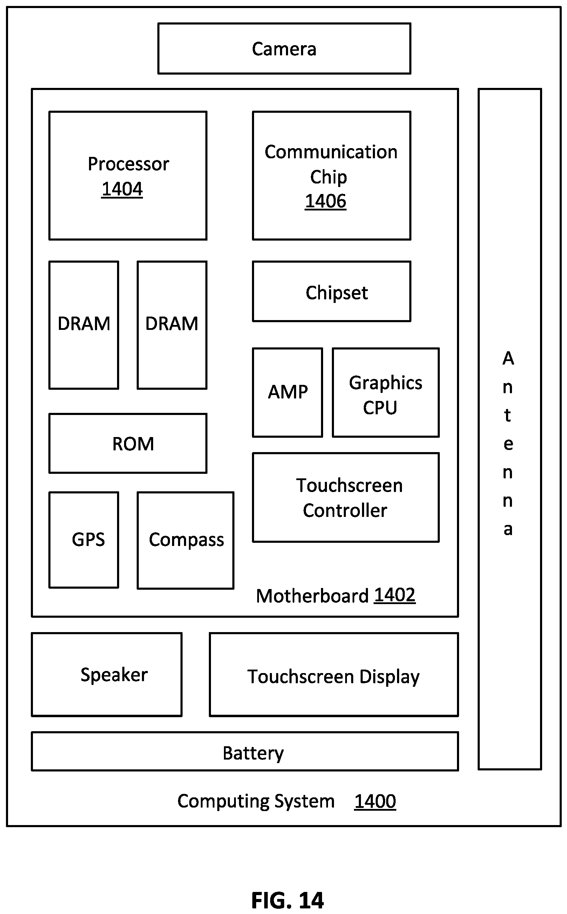

FIG. 14 is an example computing system implemented with one or more of the integrated circuit structures as disclosed herein, in accordance with some embodiments of the present disclosure. As can be seen, the computing system 1400 houses a motherboard 1402. The motherboard 1402 may include a number of components, including, but not limited to, a processor 1404 and at least one communication chip 1406, each of which can be physically and electrically coupled to the motherboard 1402, or otherwise integrated therein. As will be appreciated, the motherboard 1402 may be, for example, any printed circuit board (PCB), whether a main board, a daughterboard mounted on a main board, or the only board of system 1400, etc.

Depending on its applications, computing system 1400 may include one or more other components that may or may not be physically and electrically coupled to the motherboard 1402. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1400 may include one or more integrated circuit structures or devices configured in accordance with an example embodiment (e.g., a module including one or more semiconductor devices that include a backside source or drain region on a frontside source or drain region to improve backside contact area, as variously provided herein). In some embodiments, multiple functions can be integrated into one or more chips (e.g., for instance, note that the communication chip 1406 can be part of or otherwise integrated into the processor 1404).

The communication chip 1406 enables wireless communications for the transfer of data to and from the computing system 1400. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1406 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1400 may include a plurality of communication chips 1406. For instance, a first communication chip 1406 may be dedicated to shorter range wireless communications such as Wi-Fi and Bluetooth and a second communication chip 1406 may be dedicated to longer range wireless communications such as GPS, EDGE, GPRS, CDMA, WiMAX, LTE, Ev-DO, and others.

The processor 1404 of the computing system 1400 includes an integrated circuit die packaged within the processor 1404. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1406 also may include an integrated circuit die packaged within the communication chip 1406. In accordance with some such example embodiments, the integrated circuit die of the communication chip includes one or more semiconductor devices as variously described herein. As will be appreciated in light of this disclosure, note that multistandard wireless capability may be integrated directly into the processor 1404 (e.g., where functionality of any chips 1406 is integrated into processor 1404, rather than having separate communication chips). Further note that processor 1404 may be a chip set having such wireless capability. In short, any number of processor 1404 and/or communication chips 1406 can be used. Likewise, any one chip or chip set can have multiple functions integrated therein.

In various implementations, the computing system 1400 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1400 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a first semiconductor region extending from a first source or drain region in a first direction, a second semiconductor region extending from a second source or drain region in the first direction, a gate structure extending over the first semiconductor region and the second semiconductor region in the second direction, a backside conductive contact on a bottom surface of the first source or drain region, and a topside conductive contact on a top surface of the first source or drain region. The first semiconductor region has a first width along a second direction different from the first direction, and the second semiconductor region has a second width along the second direction that is less than the first width.

Example 2 includes the integrated circuit of Example 1, wherein the second width is at least 50% less than the first width.

Example 3 includes the integrated circuit of Example 1 or 2, wherein the first semiconductor region comprises one or more first semiconductor nanoribbons and the second semiconductor region comprises one or more second semiconductor nanoribbons.

Example 4 includes the integrated circuit of Example 3, wherein the one or more first semiconductor nanoribbons and the one or more second semiconductor nanoribbons comprises germanium, silicon, or any combination thereof.

Example 5 includes the integrated circuit of any one of Examples 1-4, wherein the first semiconductor region extends from the first source or drain region to a third source or drain region along the first direction, and the second semiconductor region extends from the second source or drain region to a fourth source or drain region along the first direction.

Example 6 includes the integrated circuit of Example 5, wherein the topside conductive contact is a first topside contact and the integrated circuit further comprises a second topside conductive contact that extends along the second direction on the top surfaces of the third source or drain region and the fourth source or drain region.

Example 7 includes the integrated circuit of any one of Examples 1-6, wherein the first semiconductor region is aligned along the first direction with a boundary of a standard unit cell.

Example 8 includes the integrated circuit of any one of Examples 1-7, further comprising: a via on the topside conductive contact; a first conductive layer on the via such that the via extends in a third direction between the topside conductive contact and the first conductive layer, the third direction being substantially orthogonal to the first and second directions; and a second conductive layer beneath the backside conductive contact and contacting the backside conductive contact.

Example 9 includes the integrated circuit of Example 8, wherein the first conductive layer and the second conductive layer each extend along the first direction.

Example 10 includes the integrated circuit of Example 9, wherein the first conductive layer and the second conductive layer are aligned over one another in the third direction.

Example 11 is a die comprising the integrated circuit of any one of Examples 1-10.

Example 12 is an electronic device that includes a chip package having one or more dies. At least one of the one or more dies includes a first semiconductor device having a first semiconductor region extending from a first source or drain region in a first direction and a gate structure extending over the first semiconductor region in a second direction substantially orthogonal to the first direction, a second semiconductor device having a second semiconductor region extending from a second source or drain region in the first direction and the gate structure extending over the second semiconductor region in the second direction, a backside conductive contact on a bottom surface of the first source or drain region, and a topside conductive contact on a top surface of the first source or drain region. The first semiconductor region has a first width along the second direction different from the first direction, and the second semiconductor region has a second width along the second direction that is less than the first width.

Example 13 includes the electronic device of Example 12, wherein the second width is at least 50% less than the first width.

Example 14 includes the electronic device of Example 12 or 13, wherein the first semiconductor region comprises one or more first semiconductor nanoribbons and the second semiconductor region comprises one or more second semiconductor nanoribbons.

Example 15 includes the electronic device of Example 14, wherein the one or more first semiconductor nanoribbons and the one or more second semiconductor nanoribbons comprises germanium, silicon, or any combination thereof.

Example 16 includes the electronic device of any one of Examples 12-15, wherein the first semiconductor region extends from the first source or drain region to a third source or drain region along the first direction, and the second semiconductor region extends from the second source or drain region to a fourth source or drain region along the first direction.

Example 17 includes the electronic device of Example 16, wherein the topside conductive contact is a first topside contact and the at least one of the one or more dies further comprises a second topside conductive contact that extends along the second direction on the top surfaces of the third source or drain region and the fourth source or drain region.

Example 18 includes the electronic device of any one of Examples 12-17, wherein the first semiconductor region is aligned along the first direction with a boundary of a standard unit cell.

Example 19 includes the electronic device of any one of Examples 12-18, wherein the at least one of the one or more dies further comprises: a via on the topside conductive contact; a first conductive layer on the via such that the via extends in a third direction between the topside conductive contact and the first conductive layer, the third direction being substantially orthogonal to the first and second directions; and a second conductive layer beneath the backside conductive contact and contacting the backside conductive contact.

Example 20 includes the electronic device of Example 19, wherein the first conductive layer and the second conductive layer each extend along the first direction.

Example 21 includes the electronic device of Example 20, wherein the first conductive layer and the second conductive layer are aligned over one another in the third direction.

Example 22 includes the electronic device of any one of Examples 12-21, further comprising a printed circuit board, wherein the chip package is attached to the printed circuit board.

Example 23 is an integrated circuit that includes first, second, and third semiconductor devices. The first semiconductor device comprises a first semiconductor region extending from a first source or drain region to a second source or drain region in a first direction and a gate structure extending over the first semiconductor region in a second direction substantially orthogonal to the first direction. The second semiconductor device has a second semiconductor region extending from a third source or drain region to a fourth source or drain region in the first direction, and the gate structure extends over the second semiconductor region in the second direction The third semiconductor device has a third semiconductor region extending from a fifth source or drain region to a sixth source or drain region in the first direction, and the gate structure extends over the third semiconductor region in the second direction. Also, a backside conductive contact is on a bottom surface of the first source or drain region, a first topside conductive contact is on a top surface of the first source or drain region, and a second topside conductive contact that extends along the second direction is on top surfaces of each of the second source or drain region, the fourth source or drain region, and the sixth source or drain region. The first semiconductor region has a first width along the second direction, the second semiconductor region has a second width along the second direction that is less than the first width, and the third semiconductor region has a third width along the second direction that is less than the first width.

Example 24 includes the integrated circuit of Example 23, wherein the second width is substantially the same as the third width.

Example 25 includes the integrated circuit of Example 23 or 24, wherein the second width and the third width are each at least 50% less than the first width.

Example 26 includes the integrated circuit of any one of Examples 23-25, wherein the first semiconductor region comprises one or more first semiconductor nanoribbons, the second semiconductor region comprises one or more second semiconductor nanoribbons, and the third semiconductor region comprises one or more third semiconductor nanoribbons.

Example 27 includes the integrated circuit of Example 26, wherein the one or more first semiconductor nanoribbons, the one or more second semiconductor nanoribbons, and the one or more third semiconductor nanoribbons comprises germanium, silicon, or any combination thereof.

Example 28 includes the integrated circuit of any one of Examples 23-27, wherein the first semiconductor region is aligned along the first direction with a boundary of a standard unit cell.

Example 29 includes the integrated circuit of any one of Examples 23-28, further comprising: a via on the first topside conductive contact; a first conductive layer on the via such that the via extends in a third direction between the first topside conductive contact and the first conductive layer, the third direction being substantially orthogonal to the first and second directions; and a second conductive layer beneath the backside conductive contact and contacting the backside conductive contact.

Example 30 includes the integrated circuit of Example 29, wherein the first conductive layer and the second conductive layer each extend along the first direction.

Example 31 includes the integrated circuit of Example 30, wherein the first conductive layer and the second conductive layer are aligned over one another in the third direction.

Example 32 is a die comprising the integrated circuit of any one of Examples 23-31.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first semiconductor region extending from a first source or drain region in a first direction, the first semiconductor region having a first width along a second direction different from the first direction;
a second semiconductor region extending from a second source or drain region in the first direction, the second semiconductor region having a second width along the second direction that is less than the first width;
a gate structure extending over the first semiconductor region and the second semiconductor region in the second direction;
a backside conductive contact on a bottom surface of the first source or drain region; and
a topside conductive contact on a top surface of the first source or drain region.

2. The integrated circuit of claim 1, wherein the second width is at least 50% less than the first width.

3. The integrated circuit of claim 1 or 2, wherein the first semiconductor region comprises one or more first semiconductor nanoribbons and the second semiconductor region comprises one or more second semiconductor nanoribbons.

4. The integrated circuit of claim 3, wherein the one or more first semiconductor nanoribbons and the one or more second semiconductor nanoribbons comprises germanium, silicon, or any combination thereof.

5. The integrated circuit of any one of claims 1 through 4, wherein the first semiconductor region extends from the first source or drain region to a third source or drain region along the first direction, and the second semiconductor region extends from the second source or drain region to a fourth source or drain region along the first direction.

6. The integrated circuit of claim 5, wherein the topside conductive contact is a first topside contact and the integrated circuit further comprises a second topside conductive contact that extends along the second direction on the top surfaces of the third source or drain region and the fourth source or drain region.

7. The integrated circuit of any one of claims 1 through 6, wherein the first semiconductor region is aligned along the first direction with a boundary of a standard unit cell.

8. The integrated circuit of any one of claims 1 through 7, further comprising:
a via on the topside conductive contact;
a first conductive layer on the via such that the via extends in a third direction between the topside conductive contact and the first conductive layer, the third direction being substantially orthogonal to the first and second directions; and
a second conductive layer beneath the backside conductive contact and contacting the backside conductive contact.

9. The integrated circuit of claim 8, wherein the first conductive layer and the second conductive layer each extend along the first direction.

10. The integrated circuit of claim 9, wherein the first conductive layer and the second conductive layer are aligned over one another in the third direction.

11. A die comprising the integrated circuit of any one of claims 1 through 10.

12. An integrated circuit comprising:
a first semiconductor device comprising a first semiconductor region extending from a first source or drain region to a second source or drain region in a first direction and a gate structure extending over the first semiconductor region in a second direction substantially orthogonal to the first direction, the first semiconductor region having a first width along the second direction;
a second semiconductor device having a second semiconductor region extending from a third source or drain region to a fourth source or drain region in the first direction and the gate structure extending over the second semiconductor region in the second direction, the second semiconductor region having a second width along the second direction that is less than the first width;
a third semiconductor device having a third semiconductor region extending from a fifth source or drain region to a sixth source or drain region in the first direction and the gate structure extending over the third semiconductor region in the second direction, the third semiconductor region having a third width along the second direction that is less than the first width;
a backside conductive contact on a bottom surface of the first source or drain region;
a first topside conductive contact on a top surface of the first source or drain region; and
a second topside conductive contact that extends along the second direction on top surfaces of each of the second source or drain region, the fourth source or drain region, and the sixth source or drain region.

13. The integrated circuit of claim 12, wherein the second width is substantially the same as the third width.

14. The integrated circuit of claim 12 or 13, wherein the first semiconductor region is aligned along the first direction with a boundary of a standard unit cell.

15. The integrated circuit of any one of claims 12 through 14, further comprising:
a via on the first topside conductive contact;
a first conductive layer on the via such that the via extends in a third direction between the first topside conductive contact and the first conductive layer, the third direction being substantially orthogonal to the first and second directions; and
a second conductive layer beneath the backside conductive contact and contacting the backside conductive contact;
wherein the first conductive layer and the second conductive layer each extend along the first direction; and
wherein the first conductive layer and the second conductive layer are aligned over one another in the third direction.
